# EUROPEAN PATENT APPLICATION

(11) **EP 1 515 146 A1**
(43) Date of publication of application: **16.03.2005**
(21) Application number: 04468016.3
(22) Date of filing: 09.09.2004
(51) Int. Cl.: G01R 15/18

(54) **Current inductive sensor**

(30) Priority: 12.09.2003 SI 200300230
(71) Applicant: Iskraemeco, d.d., 4000 Kranj (SI)
(72) Inventor: Kregar, Vlasta, 1210 Ljubljana-Sentvid (SI); Rozman, Miro, 4248 Lesce (SI)
(74) Representative: Primozic, Alenka

(57) **Abstract**

An inductive sensor of alternate current, preferably for use in an electronic current meter basically consists of two coils (1,2) containing each two windings, one winding for current measurement and another serving as a static armour of the first winding, whereby both coils (1,2) are positioned on a printed circuit board (3) that can be independent or part of a printed circuit board of a large electronic assembly and function as a secondary winding of the sensor. The sensor of the invention is characterized in that a primary winding (4) is of such shape that its free ends are adapted to various types of connectors (DIN, BS, ANSI) of electronic electricity meters, whereas the central part of the primary winding is shaped in a way that it at least partially embraces both coils (1,2) in a relatively small distance or runs between them.

## Description

### Subject of Invention

The subject of the invention is an alternate current inductive sensor for use in an electronic electricity meter.

### Technical Problem

The technical problem solved by the invention is how to conceive such current sensor that will comprise one type of secondary measuring coils for various types of electricity meters, whereas the primary winding is different and adapted to individual, also standardized connectors, e.g. DIN, BS, ANSI and the like, whereas the primary winding and the measuring coils are conceived in a way to allow industrial manufacturing, also automated or robotised, of an inductive sensor as a whole in standard or SMD variant of printed circuit boards. At the same time the same tolerances of a product are assured to allow accurate current measurement in a declared class and the outer dimensions of the sensor will be adapted to its various building options into various current meters as an electromechanical element or as part of a large printed circuit board.

### Prior art

The known solution of this type from the patent US 4,894,610 (Richard Friedl) has the primary winding made of electrically conductive sheet metal of complicated shapes. This winding can only be manufactured in several manufacturing steps and it is relatively large with respect to a coil. In a measurement instrument it therefore occupies much space, although we strive to keep the dimensions as small as possible, because the size and shape contribute to high price.

The mechanical construction of a sensor of this type according to the patent US 6,414,475 (Dames, Colby) is also dimensionally large and has a quite large primary winding, which results in the same disadvantages as those mentioned in the above invention.

A sensor according to the patent US 5,521,572 (Goodwin, Roberts) consists of a multitude of expensive elements. Assembly of such sensor is time consuming. A variant meant for a certain purpose is not adequate for optional applications on various printed circuit boards.

### Solution to the Technical Problem

The described technical problem of the invention is solved in the following way: on a printed circuit board there are two measuring coils, which are adequately electrically connected on the board itself. The primary winding is made of an electrically conductive sheet metal in the shape of an approximate letter U. The free wings of the primary winding are implemented in various ways in compliance with the standard of the connectors according to DIN, BS or ANSI.

The coils and the primary winding are mutually coordinated as to their cross-sections and number of windings on the coils and as to the cross-section of the primary winding that depends on the maximum current, for which each sensor is foreseen.

In the mentioned embodiment of the sensor several parameters can remain constant, e.g. distance between the axes of coils, the position of terminals of coil windings. A coil carrier can therefore be the same for all types, whereas the carrier simultaneously also carries a circuit for electric connection of coil windings with other circuit elements in the broader sense.

Such concept enables a production of such sensor as a type semi-fabricated product containing one part of a current sensor, i.e. measuring secondary coils, which is the same for all meters and can be integrated into various meters, to which the second part of the sensor, i.e. primary windings, were adapted. An inductive sensor of this type occupies little space in a meter; it can be used also in applications that request steal detection and where there are two current sensors per phase. We can use two inductive sensors or an inductive sensor combined with a shunt as a current sensor.

The second embodiment foresees a more integral printed circuit board encompassing also the mentioned sensor. With some dimensions of the measuring coils and the position of winding clamps being fixed for various types of a sensor, the sensor or the entire printed circuit board encompassing the mentioned sensor can be manufactured in series mechanically, automatically or by a robot.

The construction allows simple assembling of the mechanical (primary winding) and electronic (secondary winding) part into a whole, which is interconnected free of contact via a magnetic field and covers several different current areas with as little constituent parts as possible.

An additional advantage of the solution of the invention is in that the implementation of such inductive sensors enables modular construction of the connectors of a meter for various applications, in which a use of various combinations of current sensors in one meter is required:
1) only one inductive sensor,
2) two inductive sensors, or
3) one inductive sensor or a shunt as a current sensor.

The invention will now be described in more detail in the continuation of the description by an embodiment and the enclosed drawing, on which the figures show:
- Fig. 1: three-dimensional view of a sensor of the invention for a direct meter and in a variant with a DIN connector, whereby two measuring coils are positioned on a printed circuit board
- Fig. 2: primary winding of the sensor according to the first embodiment in ground view for a direct meter and in a variant for a DIN connector
- Fig. 3a: three-dimensional view of a sensor of the invention for a direct meter in the first variant for a BS connector,
- Fig. 3b: three-dimensional view of a sensor of the invention for a direct meter in the second variant for a BS connector,
- Fig. 5: third embodiment of a primary winding of a sensor in ground view of the invention for a direct meter and in a variant with a BS connector,

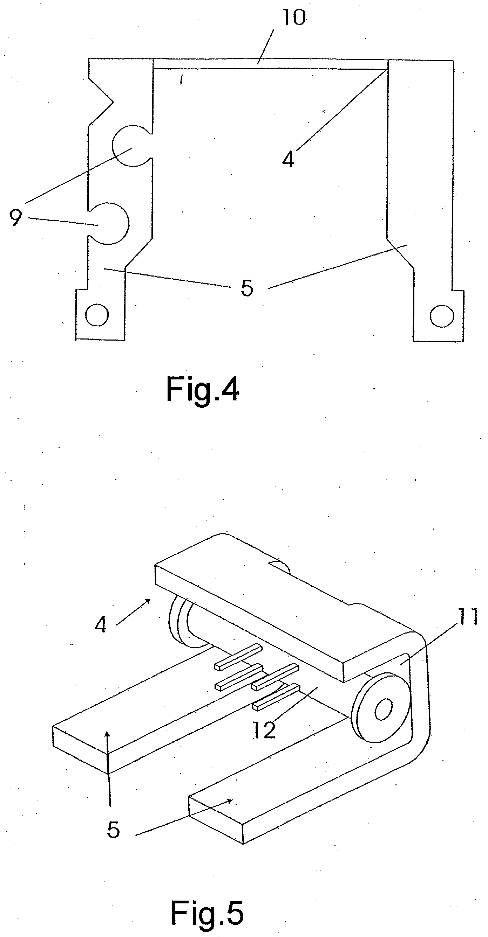

- Fig. 5: three-dimensional view of a sensor of the invention for a direct meter and in a variant for an ANSI connector, and

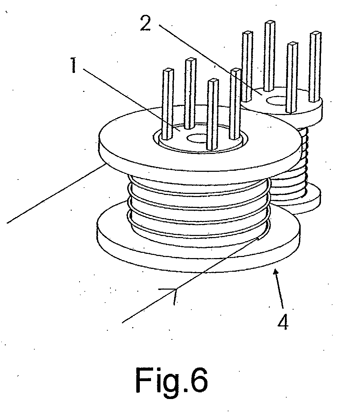

- Fig. 6: three-dimensional view of a sensor of the invention for an indirect meter.

An inductive sensor of alternate current, preferably for use in an electronic current meter basically consists of two coils 1,2 containing each two windings, one winding for current measurement and another serving as a static armour of the first winding. Both coils 1,2 are positioned on a printed circuit board 3 that can be independent or part of a printed circuit board of a large electronic assembly. The coils 1,2 in a sensor function as a secondary winding, whereas a primary winding 4 is of such shape that its free ends are adapted to various types of connectors in compliance with the standards DIN, BS or ANSI, whereas the central part of the primary winding is shaped in a way that it at least partially embraces both coils 1,2 in a relatively small distance or runs between them.

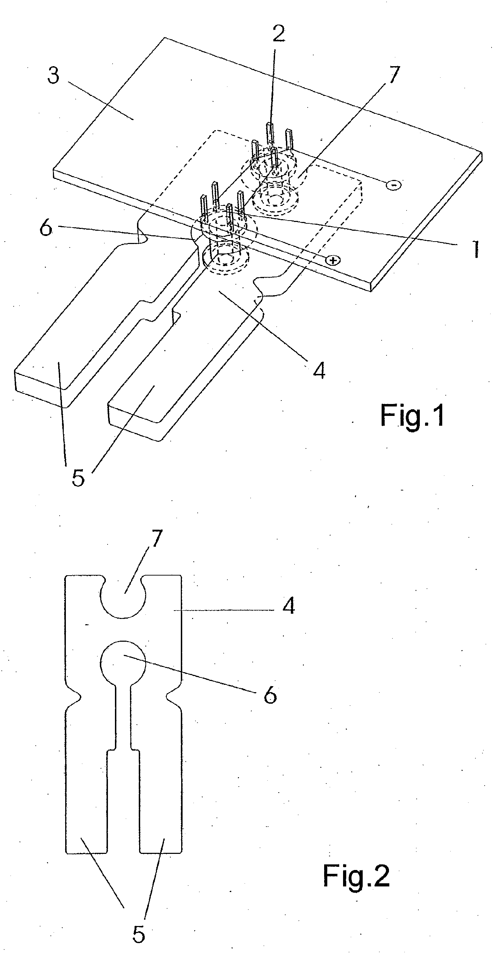

With respect to various types of connectors, to which the distances of free ends 5 of the primary winding 4 are arranged, the winding of the first embodiment as shown in Fig. 1 and Fig. 2 is conceived as an angular horseshoe-shaped body of an electrically conductive material, on the internal side of the central part of which is arranged a circular extension 6 for the coil 1, whereas on the external side of the central part there is a semicircular section 7 for the second coil 2, whereby the thickness of the primary winding 4 is smaller than the height of the coils 1 and 2 and the distances between the coils 1 and 2 and the adjacent edge of the extension 6 or the cut-out section 7 is minimal.

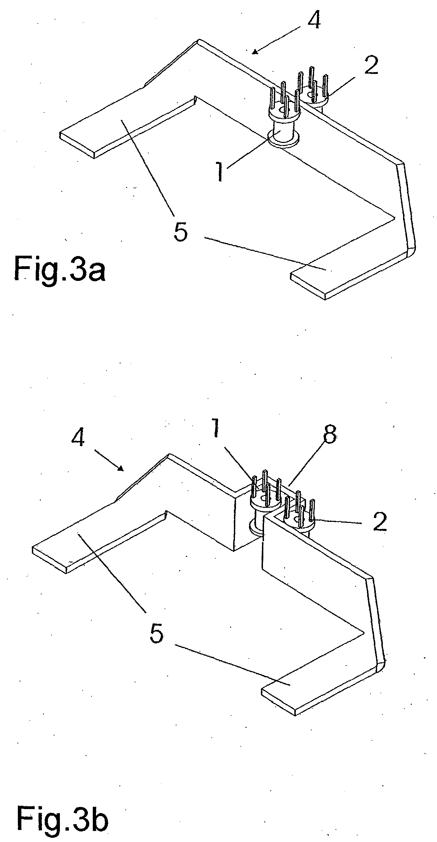

Fig. 3 shows an embodiment with a subject of the invention, the connecting ends 5 of the primary winding 4 of which are provided for a BS connector, whereby the primary winding 4 is conceived as an electrically conductive tape in the form of the letter U, the transversal end of which is folded in a rectangular way to the surface of both connecting ends 5 and there are coils 1 and 2 located on the internal and external side of the transversal end, said coils being positioned on an optional printed circuit board 3. The primary winding 4 on Fig. 3b has a square meander 8 on the conductive tape, said meander containing the coil 1 and to its right side the coil 2, whereby the centre between the coils is simultaneously the centre between free ends 5 of the primary winding 4.

Fig. 4 shows yet another embodiment of the primary winding 4 for a connector of the BS type. On one or both free ends 5 of the U-shaped winding of an electrically conductive tape there are two circle sections 9 with two coils. A central part 10 of the primary winding 4 linking both free ends 5 is folded in a rectangular way to the surface of both ends 5. The thickness of the primary winding 4 is smaller than the height of the coils 1, 2.

The embodiment of the sensor of the invention as shown on Fig. 5 is provided with a primary winding 4 with connecting ends 5 for a connector of the ANSI type. The primary winding 4 is made of an electrically conductive tape in the sense of a square letter U, whereby the transversal end is folded in a way to form a transversal groove 11 containing a double coil 12 as a secondary winding, so that both ends of the coil lie on the same axis one after another. The coil 12 is positioned on an optional printed circuit board 3.

The embodiment of the sensor of the invention shown on Fig. 6 represents a sensor for an indirect meter. The primary winding 4 is conceived as a large coil with windings made of electrically conductive wire, said winding having a diameter that depends on the maximum measured current and the number of windings depends on the size of a signal from the measuring coils. In its centre there is one of the coils 1 of the secondary winding, whereas the second coil 2 of the secondary winding is directly near the external side of the primary winding 4. The secondary coils 1, 2 are positioned on the optional printed circuit board 3.

It is understandable that a man skilled in the art can design other embodiments based on the above description or embodiments as well as products of the above description without circumventing the characteristics of the invention novelty defined in the attached patent claims.

## Claims

1. An inductive sensor of alternate current, preferably for use in an electronic current meter basically consists of two coils (1,2) containing each two windings, one winding for current measurement and another serving as a static armour of the first winding, whereby both coils (1,2) are positioned on a printed circuit board (3) that can be independent or part of a printed circuit board of a large electronic assembly and function as a secondary winding of the sensor, **characterized in that** a primary winding (4) is of such shape that its free ends (5) are adapted to various types of connectors in compliance with the standards DIN, BS or ANSI, whereas the central part of the primary winding is shaped in a way that it at least partially embraces both coils (1,2) in a relatively small distance or runs between them.

2. An inductive sensor according to claim 1, **characterized in that** the primary winding (4), the connection ends (5) of which are arranged for a DIN connector, is conceived as an angular horseshoe-shaped body, on the internal side of the central part of which is arranged a circular extension (6) for the coil (1), whereas on the external side of the central part there is a semicircular section (7) for the second coil (2), whereby the thickness of the primary winding (4) is smaller than the height of the coils (1 and 2) and the distances between the coils (1 and 2) and the adjacent edge of the extension (6) or the cut-out section (7) is minimal.

3. An inductive sensor according to claim 1, **characterized in that** the central part of the primary winding (4), the connecting ends (5) of which are provided for a BS connector, is conceived as a straight tape or a tape with a square meander (8), said meander being folded in a rectangular way to the surface of both connecting ends (5) and there are coils (1 and 2) located on the internal and external side of the electrically conductive tape in and near the meander (8), said coils being positioned on an optional printed circuit board 3.

4. An inductive sensor according to claims 1 and 3, **characterized in that** the primary winding (4), the connecting ends (5) of which are conceived for a BS connector, is conceived as a tape in the shape of a square letter U, a central part (10) of which is folded in a rectangular way to both free ends (5) that connects them, whereby on one free end there are two cut-out sections (9) in the form of a circle cut-out for the coils (1,2) and the thickness of the primary winding (4) is smaller than the height of the coils (1,2).

5. An inductive sensor according to claim 1, **characterized in that** the primary winding (4), adapted to the connector of the ANSI type, is made of a tape in the sense of a square letter U, whereby the transversal end is folded in a way to form a transversal groove (11) containing a double coil (12) as a secondary winding, so that both ends of the coil lie on the same axis one after another, whereby the coil (12) is positioned on an optional printed circuit board (3).

6. An inductive sensor according to claim 1, **characterized in that** the primary winding (4), used for indirect electronic electricity meters, is conceived as a large coil, in the centre of which there is one of the measuring coils (1) of the secondary winding, whereas the second measuring coil (2) of the secondary winding is directly near the external side of both concentric coils (1) and (4), whereby the coils (1, 2) are positioned on an optional printed circuit board (3).

7. An inductive sensor according to claims 1 and 3, **characterized in that** it is implemented in a way to allow assembly of two sensors per phase in one meter, namely an inductive sensor in a combination with a shunt as the current sensor or a combination of two inductive sensors.
